Europäisches Patentamt

European Patent Office

Office européen des brevets

(11) Publication number: **0 041 776**
**B2**

(12) **NEW EUROPEAN PATENT SPECIFICATION**

(45) Date of publication of the new patent
specification: **14.03.90**

(21) Application number: **81302078.1**

(22) Date of filing: **11.05.81**

(51) Int. Cl.⁵: **H 01 L 21/76,** H 01 L 21/31,
H 01 L 21/268

(54) Method of manufacturing a semiconductor device comprising an isolation structure.

(30) Priority: **14.05.80 JP 63573/80**

(43) Date of publication of application:
**16.12.81 Bulletin 81/50**

(45) Publication of the grant of the patent:
**16.04.86 Bulletin 86/16**

(45) Mention of the opposition decision:
**14.03.90 Bulletin 90/11**

(84) Designated Contracting States:
**DE FR GB NL**

(56) References cited:
**DE-A-2 408 402**
**DE-A-2 408 402**
**DE-B-2 825 212**
**GB-A-2 023 926**
**GB-A-2 023 926**
**GB-A-2 075 749**
**GB-A-2 075 749**
**US-A-3 998 673**
**US-A-3 998 673**

**Solid State Technology, April 1979, pp. 143-148,
A.C. Greenwald, R.G. Little: "Pulsed electron-
beam processing of semiconductor devices"**

(73) Proprietor: **FUJITSU LIMITED
1015, Kamikodanaka Nakahara-ku
Kawasaki-shi Kanagawa 211 (JP)**

(72) Inventor: **Sakurai, Junji
7-11, Seta 4-chome
Setagaya-ku Tokyo 158 (JP)**

(74) Representative: **Sunderland, James Harry et al
HASELTINE LAKE & CO Hazlitt House 28
Southampton Buildings Chancery Lane
London WC2A 1AT (GB)**

EP 0 041 776 B2

## Description

### Background of the Invention
### Field of the Invention

This invention relates to a method for manufacturing a semiconductor device having a semiconductor substrate, a plurality of active elements such as bipolar transistors or Metal-Insulator-Semiconductor (MIS) type transistors formed in the substrate and an isolation region formed on the substrate for isolating the active elements from one another. More particularly, the invention relates to a method for forming a minute field isolation structure on a semiconductor substrate for an integrated circuit device.

### Description of the Prior Art

In a semiconductor integrated circuit device, a plurality of active elements or functional elements formed in a semiconductor substrate are electrically isolated from one another by a field isolation system. The region for the field isolation is comprised of a deep impurity diffusion region or a thermally grown thick oxide film in conventional devices. Such a conventional field isolation structure has problems that a high temperature process hours long is necessary for its formation and the fine patterning of the field region is difficult. The latter problem is difficult because it results from the fact that either impurity diffusion or thermal oxidation for forming the field region is controlled by a diffusion phenomenon and accordingly the width of the region cannot be narrower than the depth. In order to solve these problems, insulator isolation structures in which a groove is formed on a surface of a substrate where the isolation region is to be formed and an insulator or semiconductor material is filled therein have been proposed. Such a groove, if formed by a conventional anisotropic etching technique or a dry etching technique, can have a smaller width than its depth. This means that the isolation structure can be miniaturized to achieve a high integration density. Moreover, if a conventional chemical vapor deposition (CVD) technique is employed to form the insulator or semiconductor layer for filling the groove, a high temperature as in the impurity diffusion or thermal oxidation process is not required. For these advantages, various processes for forming the insulator isolation structure as explained above have been proposed and tried. However, most of them have not succeeded because of the fatal disadvantage that a polishing or lapping process is necessary to remove the insulator or semiconductor layer on the substrate except in the groove. This lapping process to remove only the insulator or semiconductor layer on the substrate has a poor reproducibility and is difficult to be carried out without damaging the substrate.

DE—A—2 408 402 discloses a method of manufacturing a semiconductor device having a semiconductor substrate, a plurality of elements formed in the substrate, an isolation region formed in the substrate for isolating the elements from one another, the method comprising the steps of:—

forming a groove for forming the isolation region in the substrate

covering the surface in the groove with an insulating layer, and

depositing further insulating material in the groove to fill the groove.

The further insulating material is deposited so as to extend also on the surface at which the mouth of the groove opens, beyond the groove. The material is removed substantially down to that surface, leaving the further insulating material in the groove.

### Summary of the Invention

According to the present invention, there is provided a method for manufacturing a semiconductor device having a semiconductor substrate, a plurality of active elements formed in said substrate and an isolation region formed in said substrate for isolating said active elements from one another, the method comprising the steps of:

forming a groove for forming said isolation region in said substrate,

covering the surface in the groove with an insulating layer; and

forming on said insulating layer, at least in and around said groove, a further layer, characterized in that:

the further layer is of a material capable of being fluidized when heated, said further layer having a thickness in the groove less than the depth of the groove and less than half the width of the groove,

and in that the method comprises a further step of:

irradiating the further layer with an energy beam to selectively heat the further layer and let the same flow into said groove thereby to fill up the groove with said material.

An embodiment of this invention can provide a method for forming a field isolation structure having a minute width thereby to improve the integration density of an integrated circuit device.

An embodiment of this invention can provide a method for forming a field isolation structure without a heat treatment involving a high temperature for a long time.

An embodiment of this invention can provide a method for forming a field isolation structure by which the surface of the substrate can be made flat without any polishing or lapping process.

An embodiment of this invention can provide a method for forming a field isolation structure on a substrate which does not cause any thermal damage due to a high temperature process to active elements formed in the substrate.

The groove for forming the field isolation region may preferably be formed by an anisotropic etching technique or a dry etching technique as is well known in the art so that the groove had a small width relative to its depth thereby to lessen the area for the field isolation structure. A conventional plasma etching, reactive sputter etching or ion beam etching technique is particularly preferable for this purpose. A sufficiently thin insulating layer relative to the depth and width of the groove is formed on the substrate to cover the surface of the substrate at least in the groove. Thereafter, the abovementioned further layer is formed on the substrate preferably by a conventional CVD technique. The thickness of this further layer is selected to be less than the depth and half of the width of the groove. This layer may be formed only in and round the groove.

As the material of the further layer, an impurity containing glass, particularly phosphorus silicate glass (PSG), or silicon is preferable. Among these, it is preferable to use PSG as the material in combination with a laser generating an ultra-red laser beam having a wave length of about 10 microns such as a carbon dioxide gas laser. Such an ultra-red laser beam is not substantially absorbed in the substrate silicon but in PSG thereby to selectively heat and melt the PSG layer formed in the groove on the substrate. In case silicon is employed to fill up the groove, a laser beam generated from, for example, a YAG laser or argon laser may be useful to heat the silicon layer in the groove. In this case, most of the energy of the laser beam is absorbed at the surface portion of the silicon layer when the beam is irradiated thereon, and the silicon layer begins to melt at its surface portion. Thus, the silicon layer can be melted without substantially heating the silicon substrate thereunder. In any case, the insulating layer formed under the glass layer or silicon layer is useful to prevent the substrate from contacting with the melted glass or silicon so that any thermal damage to the substrate or active elements formed therein is avoided. Moreover, the insulating layer prevents the substrate from being diffused with an impurity contained in the glass layer which would otherwise produce an undesirable impurity diffusion region in the substrate. In case a silicon layer is formed in the groove, the underlying insulating layer is also useful to electrically isolate the silicon layer from the substrate so that the isolation is achieved. The insulating layer may be a thermally grown silicon dioxide formed on the silicon substrate and have a thickness more than 50 nm which is sufficient to prevent the thermal damage, and to block the impurity diffusion from the glass layer in the step of fluidifying or melting the glass layer by the irradiation of a high energy beam such as a laser beam because the melting lasts only a very short period of time, for example, less than 10 micro-seconds. A silicon dioxide film having a thickness more than 50 nm is also sufficient to assure the isolation between the substrate and the silicon layer in the groove.

When the glass or silicon layer in the groove is selectively heated up to a sufficiently high temperature to fluidify or melt the glass or silicon, the layer begins to flow into the groove and ultimately fills up the same to make the surface flat and smooth. In this melting step, the surface tension of the molten layer rather than gravity is dominant for the flow of the material so that the surface becomes flat and smooth very quickly. Therefore, it is sufficient to melt the layer for several micro-seconds in order to obtain a desirable flat surface. Thus a flat and smooth surface suitable for forming a wiring layer for integrated circuit thereon without a risk of disconnection of the layer is obtained without a grinding or lapping process.

Unlike the conventional method for forming an isolation structure, the formation of the field isolation region in accordance with the present invention may be carried out even after active regions for active elements have already been formed in the substrate because these regions are not thermally damaged even in the melting step described above. Yet, the material filled in the groove has an excellent isolation property because it consists of a CVD insulator or silicon and is sufficiently annealed in the melting step to become dense. The isolation structure by the present invention is applicable not only to bipolar type integrated circuit devices but also to MIS type devices.

Brief Description of the Drawings

Reference is made, by way of example, to the accompanying drawings, in which:

Figure 1 to Figure 4 are respective cross-sectional views of a semiconductor substrate, for a basic explanation of a process for forming an isolation region by an embodiment of this invention;

Figure 5 to Figure 12 are respective cross-sectional views of a part of a substrate in the course of a preferred method embodying this invention for manufacturing a bipolar type integrated circuit;

Figure 13 to Figure 19 are respective cross-sectional views of a part of a substrate in the course of a preferred method embodying this invention for an MIS type integrated circuit.

Detailed Description of the Invention

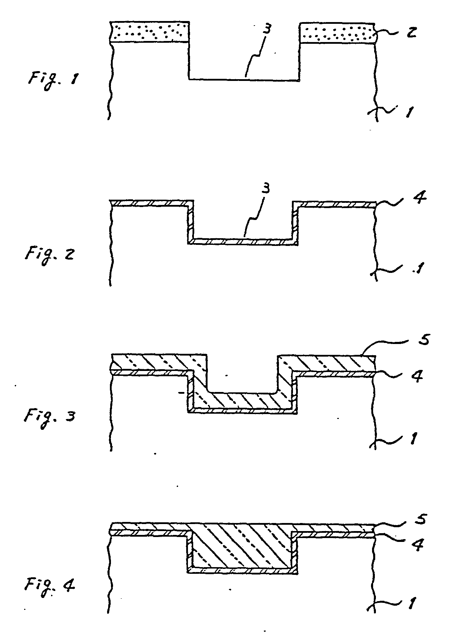

Referring to Figures 1 to 4, the basic process according to the invention is explained hereinafter. In the first step, a silicon substrate 1 is prepared and a photoresist layer 2 having a predetermined pattern for forming a groove is formed thereon by a conventional photolithography technique. The groove 3 is formed by, for example, a conventional reactive sputter etching technique, with the photoresist layer 2 used as an etching mask as shown in Fig. 1. The dimension of the groove depends on the type of the device to be manufactured as in the case of the conventional isolation structure. After the removal of the photoresist, the substrate is subject to a thermal oxidation treatment to form a silicon-dioxide film 4 having a thickness of 50 to 100 μm on the surface of the substrate 1 as shown in Figure 2. This oxide film 4 in the groove 3 functions as a blocking film to prevent any undesirable thermal damage or impurity diffusion in the later process steps. Thereafter, for example, a PSG layer 5 is formed on the substate by a conventional CVD technique. The thickness of this layer 5 should be less than the depth of the groove 3 and also less than half of its width as shown in Figure 3 so that the layer 5 does not completely fill up the groove at this stage. Unnecessary portions of layer 5 may be selectively removed so as to remain only in the groove 3 and at its fringe. Next, a laser beam such as a carbon dioxide laser beam having a wavelength of 10.6 μm is irradiated from above onto the PSG layer 5 to melt and fluidify the PSG layer 5. The optimum condition of the irradiation energy depends on the thickness of the layer 5. However, the condition is not critical because the laser beam is not substantially absorbed in the substrate but in the PSG layer 5 to selectively heat the same. Moreover, the PSG layer 5 tends to preferentially melt at the thick portion that is in the groove 3 where the fluidifying of the layer 5 is necessary because the absorption of the beam is large at this portion. Thus the PSG layer 5 is fluidified and flows into the groove 3 due to its surface tension and its surface becomes smooth and flat as shown in Figure 4. In this melting step, the thermally grown oxide film 4 prevents the diffusion of phosphorus which is an n type impurity into the substrate 1 form the PSG layer 5. In addition, any substantial thermal damage to the substrate or active elements therein by the molten PSG layer is prevented by this blocking film 4.

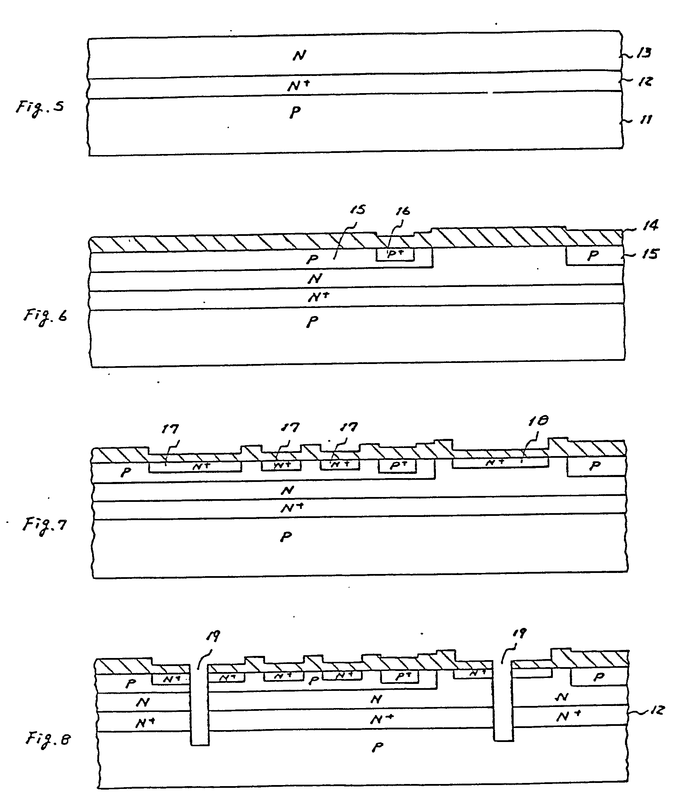

A preferred embodiment of the present invention for manufacturing a bipolar type integrated circuit device is hereinafter described with reference to Figure 5 to Figure 12. First of all, in a P type silicon substrate 11 having a specific resistivity of 0.1 to 0.01 ohm-cm, an N type layer 12 having an inpurity concentration of $5 \times 10^{19} \sim 1 \times 10^{20}$ cm$^{-3}$ is formed by a conventional process by diffusing antimony. This layer 12 becomes a so-called buried diffusion layer. In contrast to a conventional process, this buried diffusion layer 12 may be formed continuously on the entire surface of the substrate 11. Thereafter, an N type silicon epitaxial layer 13 containing phosphorus as the N type impurity in the concentration of $5 \times 10^{14}$ cm$^{-3}$ is formed on the substrate by an ordinary epitaxial growth process. The resultant cross-section of the substrate is shown in Figure 1.

In the process of the embodiment, process steps for forming regions for active elements in the substrate are carried out prior to the formation of the isolation region. However, these steps are essentially the same as those in the conventional process. Referring to Figure 6, a silicon dioxide film 14 is formed on the substrate, P type base regions 15 and base contact regions 16 of high impurity concentration are formed successively in the epitaxial layer 13 by conventional impurity diffusion processes with the oxide film 14 used as a diffusion mask. Next, emitter regions 17 and collector regions 18 are formed by diffusion of an N type impurity in high concentration as shown in Figure 7. Thus, the formation of active regions in the substrate for forming active elements are completed.

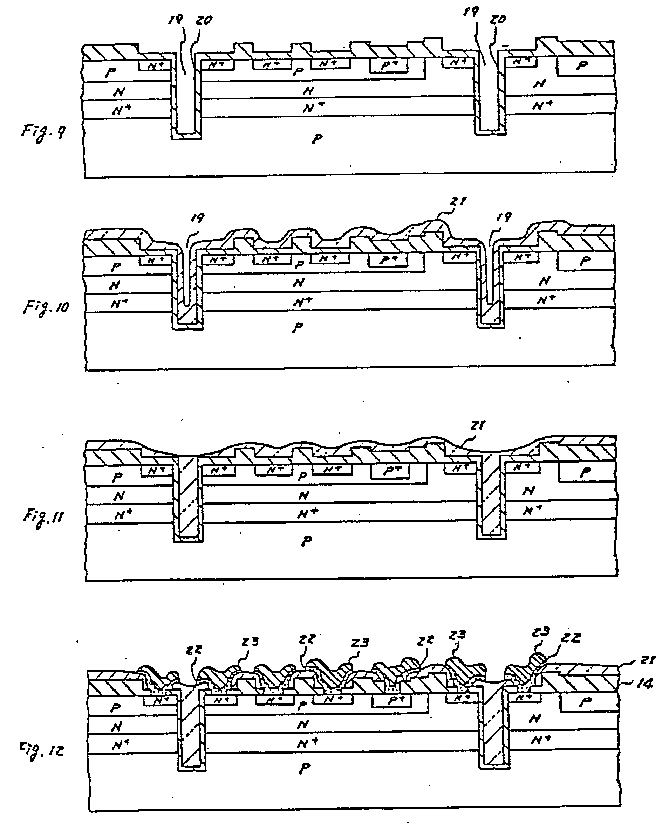

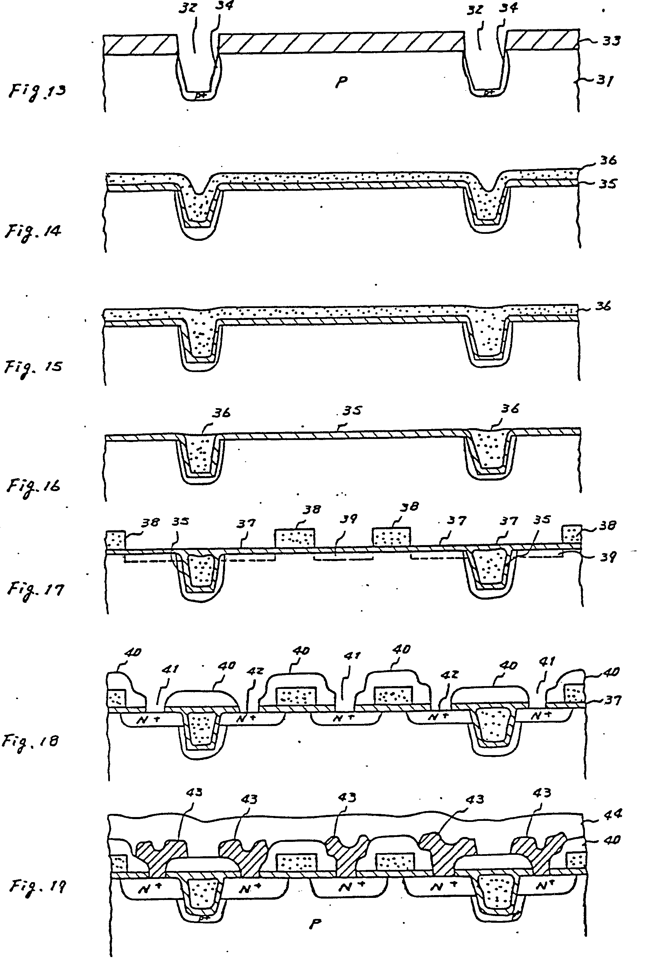

After the process steps described above, isolation regions are formed in the substrate as explained below. For the first step, a groove 19 is formed in the substrate at a portion where the isolation region is to be formed as shown in Figure 8 by a conventional reactive sputter etching technique with a photoresist film used as a mask. The groove 19 should be deep enough to penetrate the buried diffusion layer 12 so as to completely isolate island-shaped N type collector regions from one another. Then, the substrate is subjected to a thermal oxidation treatment to form a silicon dioxide film 20 having a thickness of 50 to 100 nm on the exposed silicon surface in the groove 19 as shown in Figure 9. In Figure 10, a PSG layer 21 is formed on the substrate by a conventional CVD method. This PSG layer 21 should have a thickness less than the depth of the groove 19 and also less than half of the width of the groove 19. Typically, the groove 19 in a bipolar type device as in this embodiment is relatively deep, for example as deep as 5 to 10 μm. On the other hand, it may be made sufficiently narrow to save area. Assuming that the width of the groove 19 is 4 μm, the appropriate thickness of the PSG layer 21 is about 1.5 μm.

Then a baser beam generated by a carbon dioxide pulse laser is irradiated onto the PSG layer 21 from above to melt or fluidify the layer 21. For example, the irradiation energy is 4 to 5 joule/cm$^2$ with the pulse width of 5 micro-seconds and the diameter of the laser spot of 1 mm. The beam is preferably scanned with a pitch of 0.5 mm so that adjacent spots partially overlap one another. The PSG layer 21 is melted instantaneously by the irradiation of the laser beam and immediately flows into the groove 19 due to the surface tension. In this step, the blocking oxide film 20 prevents any substantial diffusion of phosphorus from the PSG layer into the substrate because the heating by the beam lasts only a very short period of time. As a result of this melting step, a smooth and flat surface as shown in Figure 11 is obtained on the substrate. Thus the formation of the isolation region is completed.

The succeeding process steps are the same as those in the conventional process, in which electrode windows are formed in the insulator layers on the substrate, a polycrystal silicon layer of about 40 nm and an aluminium layer of 500 to 1000 nm are successively formed thereon, and patterning of the silicon and aluminium layers is carried out to form electrodes or wirings for the integrated circuit. The resultant structure is shown in Figure 12 in which 22 is the silicon layer and 23 is the aluminium layer. The wiring comprised of the both layers, though not shown in the Figure, extends over the groove 19 on the PSG layer 21 without a potential risk of disconnection due to steep steps which would otherwise exist on the isolation region, i.e. on the groove 19.

With reference to Figure 13 to Figure 19, a preferred embodiment of this invention for manufacturing an MIS type integrated circuit device is described hereinunder. For the first step, a groove 32 having a depth of, for example, 1 to 2 μm is formed in a P type silicon substrate 31 at a portion where an field isolation region is to be formed with a photoresist file 33 used as an etching mask. The substrate has a crystallographic surface orientation of (100) on its major surface and the abovementioned etching may be carried out by a well known unisotropic etching method so that (111) surface is exposed; however, other etching techniques may be employed as well for the formation of the groove 32. The photoresist film 33 is also used as a mask thereafter in the ion implantation process for forming a channel stop or channel cut region 34 in the substrate 31 at the portion under the groove 32. By the implantation of boron ions, the channel cut region 34 is formed as shown in Figure 13.

After removing the photoresist film, the substrate is subjected to a thermal oxidation treatment to form a silicon dioxide film 35 having a thickness of 50 to 100 nm on the entire surface of the substrate. Then, a polycrystal silicon layer 36 is formed on the substrate as shown in Figure 14. The silicone layer 36 has a thickness (for example, 0.5 to 1 μm) which is less than half of the width of the groove 32 as in the case of the preceding embodiment.

Onto the silicon layer, a layer beam from a CW argon laser is irradiated to selectively heat and melt the same. An example of the optimum irradiation condition is as follows: the output power of the argon laser is 10 to 15 W, the diameter of the beam spot 50 microns, the scanning speed 10 cm/sec, the scanning pitch 25 microns. In this irradiation step, the oxide film 35 thermally insulates the substrate 31 from the molten silicon layer thereon so that no part of the substrate is melted. The molton silicon flows into the groove due to surface tension so as to make its surface smooth and flat as shown in Figure 15.

Then the silicon layer 36 is etched until the underlying oxide film 35 is exposed except in the groove as shown in Figure 16. The exposed oxide film is also etched off and then the substrate is subjected to a thermal oxidation treatment to form again a silicon dioxide film 37 for a gate oxide film. The surface of the remaining silicon layer 36 in the groove is also oxidized so that the silicon layer 36 is completely surrounded by the oxide films 35 and 37. An implantation of boron ions into the substrate through the oxide film 37 may be executed at this stage to adjust threshold voltage of MIS transistors to be manufactured. Another polycrystal silicon layer for forming gate electrodes 38 is formed by an ordinary CVD technique on the oxide film 37 and its patterning is carried out by a conventional photo-etching technique to form gate electrodes 38 as shown in Figure 17. Then, phosphorus ions are implanted through the oxide film 37 to form phosphorus containing regions 39 for source or drain regions with the polycrystal silicon layer 38 for gate used as a mask for blocking the ions. The implanted ions into the silicon layer 38 is useful to render the layer 38 more conductive.

A PSG layer 40 is formed on the substrate and contact windows 41 for source and drain are formed through the PSG layer 40 and the oxide film 37 as shown in Figure 18. The substrate is then subjected to an annealing treatment to activate the implanted phosphorus ions to form N type source and drain regions 32. Thereafter aluminium electrodes 43 are formed and cover PSG layer 44 is formed thereon as in the conventional device. Thus, the integrated circuit device including MIS type transistors each isolated by the field isolation structure is completed as shown in Figure 19.

An embodiment of the present invention provides a method for forming a field isolation structure for a semiconductor device, particularly for an integrated circuit device, in which a groove is formed in a semiconductor substrate, an insulating layer is formed on the substrate at least in the groove, a glass layer or a silicon layer is formed thereon, and thereafter a high energy beam such as a laser beam is irradiated onto the glass or silicon layer to selectively heat the same thereby to melt of fluidify the layer and let the same flow into the groove. A smooth and flat surface is obtained through the above melting process, being effective for preventing any disconnection of wiring layers formed thereon. The method is particularly useful to obtain a minute field isolation structure effective to improve the integration density of the device.

**Claims**

1. A method for manufacturing a semiconductor device having a semiconductor substrate (1; 11, 12, 13; 31), a plurality of active elements formed in said substrate (1; 11, 12, 13; 31) and an isolation region formed in said substrate (1; 11, 12, 13; 31) for isolating said active elements from one another, the method comprising the steps of:

forming a groove (3; 19; 32) for forming said isolation region in said substrate (1; 11, 12, 13; 31);

covering the surface in the groove (3; 19; 32) with an insulating layer (4; 20; 35); and

forming on said insulating layer (4; 20; 35), at least in and around said groove (3; 19; 32), a further layer (5; 21; 36) of a material capable of being fluidified when heated; characterized in that:

said further layer has a thickness in the groove less than the depth of the groove and less than half the width of the groove,

and in that the method comprises a further step of:

irradiating the further layer (5; 21; 36) with an energy beam to selectively heat the further layer (5; 21; 36) and let the same flow into said groove (3; 19; 32) thereby to fill up the groove (3; 19; 32) with said material.

2. A method as claimed in claim 1, wherein said energy beam is a laser beam.

3. A method as claimed in claim 1 or 2, wherein said material consists of a glass.

4. A method as claimed in claim 1, 2 or 3, wherein said material consists of a phospho silicate glass.

5. A method as claimed in claim 4, wherein said energy beam is a carbon dioxide gas laser beam.

6. A method as claimed in claim 1 or 2, wherein said material consists of silicon.

7. A method as claimed in any preceding claim, wherein said insulating layer (4; 20; 35) consists of silicon dioxide.

**Patentansprüche**

1. Verfahren zur Herstellung einer Halbleitervorrichtung mit einem halbleitersubstrat (1; 11, 12, 13; 31), einer Vielzahl von aktiven Elementen, die in dem genannten Substrat (1; 11, 12, 13; 31) gebildet sind, und einem Isolationsbereich, der in dem genannten Substrat (1; 11, 12, 13; 31) gebildet ist, um die genannten aktiven Elemente voneinander zu isolieren, welches Verfahren die folgenden Schritte umfaßt:

Bilden einer Nut (3; 19; 32), um den genannten Isolationsbereich in dem genannten Substrat (1; 11, 12, 13; 31) zu bilden,

Bedecken der Oberfläche der Nut (3; 19; 32) mit einer isolierenden Schicht (4; 20; 35); und

Bilden, auf der genannten isolierenden Schicht (4; 20; 35), wenigstens in und um die genannte Nut (3; 19; 32), einer weiteren Schicht (5; 21; 36) aus einem Material, den bei Erwärmung verflüssigt werden kann, dadurch gekennzeichnet, daß die genannte weitere Schicht in der Nut eine Dicke hat, die geringer als die Tiefe der Nut und geringer als die halbe Breite der Nut ist;

und daß das Verfahren ferner den folgenden Schritt umfaßt;

Bestrahlen der weiteren Schicht (5; 21; 36) mit einem Energiestrahl, um selektiv die weitere Schicht (5; 21; 36) zu erwärmen und dieselbe in die genannte Nut (3; 19; 32) fließen zu lassen, um dadurch die Nut (3; 19; 32) mit dem genannten Material aufzufüllen.

2. Verfahren nach Anspruch 1, bei dem der genannte Energiestrahl ein Laserstrahl ist.

3. Verfahren nach Anspruch 1 oder 2, bei dem das genannte Material aus einem Glas besteht.

4. Verfahren nach Anspruch 1, 2 oder 3, bei dem das genannte Material aus Phosphorsilikatglas besteht.

5. Verfahren nach Anspruch 4, bei dem der genannte Energiestrahl ein Kohlendioxid-Gaslaser-Strahl ist.

6. Verfahren nach Anspruch 1 oder 2, bei dem das genannte Material aus Silicium besteht.

7. Verfahren nach einem der vorhergehenden Ansprüche bei dem die genannte isolierende Schicht (4; 20; 35) aus Siliciumdioxid besteht.

**Revendications**

1. Procédé de fabrication d'un dispositif semi-conducteur possédant un substrat semiconduc-teur (1; 11, 12, 13; 31) plusièurs éléments actifs formés dans ledit substrat (1; 11, 12, 13; 31) et une région d'isolation formée dans ledit substrat (1; 11, 12, 13; 31) pour isoler les éléments actifs les uns des autres, le procédé comprenant les opérations suivantes;

former une rainure (3; 19; 32) afin de former ladite région d'isolation dans ledit substrat (1; 11, 12, 13; 31).

couvrir le surface se trouvant dans la rainure (3; 19; 32) au moyen d'une couche isolante (4; 20; 35); et

former sur ladite couche isolante (4; 20; 35), au moins dans et autour de la rainure (3; 19; 32), une couche supplémentaire (5; 21; 36) faite d'un matériau susceptible d'être rendu fluide par l'application de chaleur; caractérisé en ce que

ladite couche supplémentaire possède une épaisseur, dans la rainure, qui est inférieure à la profondeur de la rainure et inférieure à la moitié de la largeur de la rainure,

et en ce que le procédé comprend une opération supplémentaire consistant à:

irradier le couche supplémentaire (5; 21; 36) au moyen d'un faisceau énergétique afin de chauffer sélectivement la couche supplémentaire (5; 21; 36) et laisser s'écouler celle-ci; dans ladite rainure (3; 19; 32) pour remplir la rainure (3; 19; 32) avec ledit matériau.

2. Procédé selon la revendication 1, où ledit faisceau énergétique est un faisceau laser.

3. Procédé selon la revendication 1 ou 2, où ledit matériau est constitué d'un verre.

4. Procédé selon la revendication 1, 2 ou 3, où ledit matériau est constitué de verre au phospho-silicate.

5. Procédé selon la revendication 4, où ledit faisceau énergétique est un faisceau de laser à gaz au dioxyde de carbone.

6. Procédé selon la revendication 1 ou 2, où ledit matériau est constitué de silicium.

7. Procédé selon l'une quelconque des revendications précédentes, où ladite couche isolante (4; 20; 35) est constituée de dioxyde de silicium.

Fig. 1

Fig. 2

Fig. 3

Fig. 4

Fig.5

N ~ 13

N⁺ ~ 12

P ~ 11

Fig.6

15    16

14

P        P⁺        P ~ 15

N

N⁺

P

Fig.7

17        17    17        18

P    N⁺    N⁺    N⁺    P⁺    N⁺    P

N

N⁺

P

Fig.8

19                19

P    N⁺    N⁺    N⁺    P    N⁺    P⁺    N⁺    P

N        N        N

N⁺        N⁺        N⁺ ~ 12

P

Fig. 9

Fig. 10

Fig. 11

Fig. 12

Fig. 13

Fig. 14

Fig. 15

Fig. 16

Fig. 17

Fig. 18

Fig. 19